(19) Europäisches Patentamt
European Patent Office
Office européen des brevets

(11) **EP 2 675 064 B1**

(12) **EUROPEAN PATENT SPECIFICATION**

(45) Date of publication and mention
of the grant of the patent:
**12.02.2020 Bulletin 2020/07**

(51) Int Cl.:
***H03H 7/40*** *(2006.01)*        ***H01J 37/32*** *(2006.01)*

(21) Application number: **12305684.8**

(22) Date of filing: **15.06.2012**

(54) **Electrical circuit to impedance match a source and a load at multiple frequencies, method to design such a circuit**

Elektrische Schaltung zur Impedanzanpassung einer Quelle an eine Last bei mehreren Frequenzen, Verfahren zum Entwurf solch einer Schaltung

Circuit électrique pour adapter l'impédance d'une source et d'une charge sur une large gamme de fréquences, procédé pour concevoir un tel circuit

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**18.12.2013 Bulletin 2013/51**

(73) Proprietors:
• **École Polytechnique**
  **91120 Palaiseau (FR)**
• **Centre National de la Recherche Scientifique**
  **75016 Paris (FR)**

(72) Inventors:
• **Johnson, Erik**
  **75020 Paris (FR)**
• **Booth, Jean-Paul**
  **91470 Boullay les Troux (FR)**

(74) Representative: **Gevers & Orès**
**Immeuble le Palatin 2**
**3 Cours du Triangle**
**CS 80165**
**92939 Paris La Défense Cedex (FR)**

(56) References cited:
**US-A1- 2002 118 067        US-A1- 2004 000 948**
**US-A1- 2005 134 186        US-A1- 2006 170 492**
**US-A1- 2007 194 628        US-B1- 6 331 815**

• **HANCOCK T M ET AL: "A 12-GHz SiGe Phase Shifter With Integrated LNA", IEEE TRANSACTIONS ON MICROWAVE THEORY AND TECHNIQUES, IEEE SERVICE CENTER, PISCATAWAY, NJ, US, vol. 53, no. 3, 1 March 2005 (2005-03-01), pages 977-983, XP011128147, ISSN: 0018-9480, DOI: 10.1109/TMTT.2004.842479**
• **CZARNETZKI U ET AL: "The Electrical Asymmetry Effect - A novel and simple method for separate control of ion energy and flux in capacitively coupled RF discharges", JOURNAL OF PHYSICS: CONFERENCE SERIES, INSTITUTE OF PHYSICS PUBLISHING, BRISTOL, GB, vol. 162, no. 1, 1 April 2009 (2009-04-01), page 12010, XP020157448, ISSN: 1742-6596**

**Description**

BACKGROUND OF THE INVENTION

Field of the invention

The present invention relates to the field of impedance matching, and in particular, to the field of plasma processing systems.

Description of the related Art

Capacitively coupled plasma reactors for etching or deposition have been historically excited with a sinusoidal voltage waveform at one frequency (typically radio-frequencies in the 1-900 MHz range). As the characteristic impedance of a capacitively coupled plasma-processing system is complex and variable, and is not typically the same as (and therefore matched to) the output of the power generator (typically 50 Ω resistive), a matching circuit is required to maximize power transfer to the load.

It was later noted that enhanced process performance and control could be achieved by applying voltage waveforms at two (unsynchronised) frequencies to either the powered electrode or the substrate chuck. To apply this concept, two radiofrequency (RF) generators and two independent match boxes are used.

Recently, the use of voltage waveforms consisting of the sum of synchronised harmonics of a base frequency (notably f + 2f) applied to one electrode was shown to enable independent control over ion bombardment energy and injected power (the electrical asymmetry effect). To physically implement this configuration for two frequencies requires the use of two power generators, two match boxes, and filtering to isolate the two systems. The advantages of adding additional harmonics have been demonstrated in etching applications and in the growth of thin films. Clearly, as the number of frequencies (n) increases, the number of power generators, matchboxes and filters increases (n for the generators and matchboxes and n(n-1) for the filters), making the above solution impractical. An alternative is to use a single, wideband power source which can produce the multi-frequency waveform directly. Experimental demonstrations of this technique have until now been done without impedance matching (therefore wasting large amounts of power, and limiting the input power to the process).

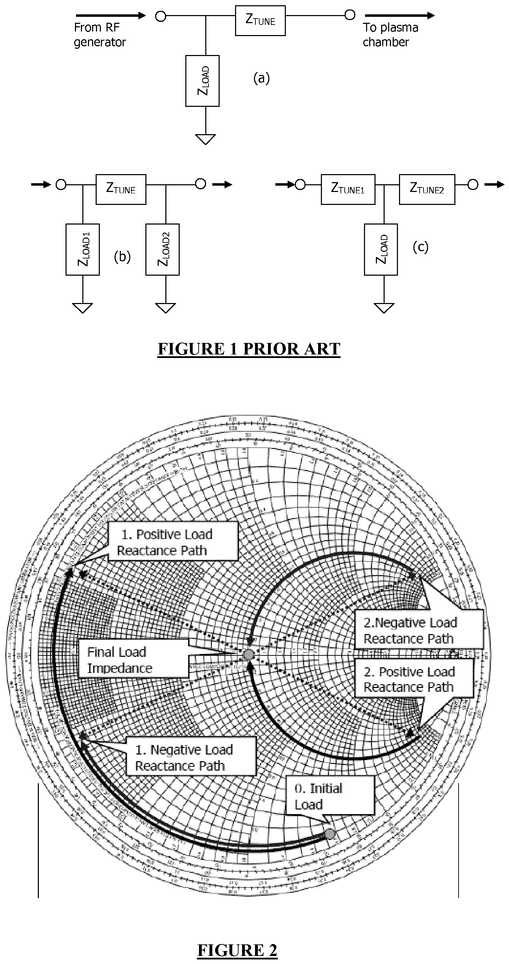

The electrical impedance seen at the power feedthrough of practical capacitively coupled plasma processing systems (CCP-PS) is typically a small, real impedance (relative to a value of 50 Ω) in series with a larger imaginary impedance. This presents a power matching challenge, as for optimal power transfer, RF power generators or amplifiers (and transmission lines/cables) are typically designed to have a characteristic output impedance of 50 Ω or 100 Ω. For maximum power transfer, the load attached to the output of the generator or amplifier must have the same characteristic impedance. To solve this problem, one solution is to use electrical matching networks to transform the impedance of the chamber to that of the amplifier. Typical impedance matching circuits for a single frequency comprise simple load and tune-type circuits in one of three different configurations: L-type, (1a), pi-type (1b) or t-type (1c), as shown below in figure 1. The load and tune impedances ($Z_{LOAD}$ and $Z_{TUNE}$) represent the impedances of capacitors ($Z=1/j\omega C$) or inductors ($Z=j\omega L$) at the frequency of operation of the RF generator.

When it is desired to simultaneously couple multiple frequencies to the CCP-PS (such as for the use of tailored voltage waveforms, which allow the generation of the so-called electrical asymmetry effect) the solution of figure 1 is no longer applicable, as the impedance of the CCP-PS will vary with frequency, as will those of the passive components within the matching box. For this reason, a different circuit design must be used.

Document US 6331815B1, referred to as D1, discloses a dual-frequency matching circuit in order to avoid long transmission line. The object of this document is to replace prior device where the matching is obtained by modifying the length of the transmission line and the "open stub", by a matching circuit constructed with inductors and capacitors.

D1 uses Smith Chart to determine components values of the matching circuit. Figure 2 of D1 discloses an example where the matching circuit follows a load path for the lower frequency and another load path for the higher frequency. The path in the Smith Chart starts from the load impedance and reach directly the constant conductance circle.

Patent document US 2006/170492, referred to as D2, discloses a dual-frequency matching circuit comprising a parallel resonance circuit and a series resonance circuit and adapted to operate at two distinct frequencies.

Patent document, US 2007/194628, referred to as D4, discloses a circuit for adapting the impedance simultaneously at a fundamental frequency and at an harmonic frequency between a generator and a load. The circuit comprises a tune circuit connected in series to the load and comprising an inductance and a a capacitance connected in series as well as a load circuit connected in parallel and comprising an inductance and a capacitance.

In a paper entitled "The Electrical Aysmmetry Effect - A novel and simple method for separate control of ion energy and flux in capacitively coupled RF discharges" published in Journal of Physics, vol. 162, no. 1, April 2009, page 12010, XP020157448, referred to as D6, Czarnetzki *et al.* describe a method for controlling separately an flux of ions and the ions energy during CCRF (Capacitely Coupled Radio Frequency) discharges at multiple frequencies including fundamental and harmonic frequencies in a chamber for etching and layer deposition for semiconductors. However, D6 does not address impedance matching.

Patent document US 2007/118067, referred to as D7, concerns an analogue amplification comprising an impedance matching circuit adapted to operated at two distinct frequencies.

None of the above cited documents describes or suggests impedance matching simultaneously for at least two pairs of frequencies.

Accordingly, the present invention is directed to providing a matching circuit and a method for efficiently exciting a plasma reactor at multiple (arbitrary) frequencies using a single (multi-frequency) generator by using a single matchbox and without the need for filtering.

Another object of the invention is to provide a matching circuit design that matches imperfectly the impedance seen by the generator but uses fewer components.

Another object of the invention is to implement a new, tuneable multi-frequency matching circuit when the impedance of the reactor is not well known.

SUMMARY OF THE INVENTION

At least one of the above-mentioned objects is achieved with a matching circuit according to the present invention to adapt electrical impedance simultaneously for at least two pairs of frequencies (consisting of a higher and a lower frequency) between a load and a generator as defined in claim 1.

Advantageously, a single, wideband power source which can produce the multi-frequency waveform directly can be used.

With the matching circuit according to the invention, the impedance seen by the generator is adapted so that at multiple frequencies ($f_n$), this impedance is similar or equal to the output impedance of the generator, therefore maximizing electrical power transfer between the generator and the load. More generally, the impedance may be matched at any number of frequencies, limited only by the number of components to be included.

The inductors and capacitors are determined such that for each frequency, the power source (the generator) sees the same impedance.

The use of two components, an inductor and a capacitor, in both the load circuit and the tune circuit, results in a perfect value of load impedance appearing at the output of the generator when the appropriate values are chosen. It is possible to use fewer components but in this case the matching will be not perfect. For example, if the output of the power generator is typically 50Ω resistive, with fewer components the matching may be imperfect, and result in a load impedance of 45Ω, as seen by the generator.

According to the invention, the load may advantageously be a capacitively coupled plasma reactor. Furthermore, the higher and lower frequencies are a fundamental frequency with one of its harmonics. The signal applied to the load may consist of the sum of synchronised harmonics of a base frequency, notably f and 2f.

According to the present invention, for each additional pair of frequencies, the matching circuit comprises an additional tune circuit in parallel to the first tune circuit, and an additional load circuit in series with the first load circuit.

The matching circuit may comprise multiple stages connected in series in order to reach the perfect impedance value when it is not possible to achieve this with only one stage. This may be useful because of the load features or the components available for the matching circuit.

In practice, the impedance of the load at the frequencies for which matching is required may not be perfectly known, and/or may be subject to drift. For this reason, at least one of the stage components is adjustable. Preferably, the adjustable component is a capacitor. All the Load and Tune capacitors in the circuits may be adjustable. Moreover, a variable inductor in the Tune circuit may be obtained by splitting the inductor into two standard inductors in series (possessing a total inductance equal to that of the original inductor), and adding an adjustable capacitor in parallel to one of these inductors. Similarly, a variable inductor in the Load circuit may be obtained by adding an adjustable capacitor in parallel with one of two series-connected inductors whose total inductance sums to that of the ideal, calculated value.

In accordance with another aspect of the present invention, there is provided a method for designing a matching circuit to adapt electrical impedance simultaneously for at least a pair of a higher and a lower frequencies between a load and a generator as defined in claim 4.

As a matter of fact, as the frequencies used by the power generator are discrete, each inductor-capacitor-pair of the tune circuit acts as an open circuit for frequencies which are far from its resonant frequency. Similarly, each inductor-capacitor-pair of the load circuit acts as a short-circuit for frequencies which are far from its resonant frequency.

Consequently, the component values of the additional components are calculated by first assuming that the values for the first tune circuit or the first load circuit are infinite or zero impedance respectively, then an iterative process is carried out to correct the additional components' values. A perfect solution may also be obtained by solving for all components simultaneously.

According to the invention, a perfect match for any two frequencies is obtainable in a single stage when:

$$X(\omega_2) - \frac{\omega_2}{\omega_2 + \omega_1}\left(X(\omega_2) + X(\omega_1)\right) \le X_{match}$$

$\pm X_{match}$ being the two solutions that provide matching in a Smith chart, one following the negative load reactance path, and one following the positive load reactance path; $\omega_i$ being the i-th angular frequency, and $X(\omega_i)$ being the

reactance of the load at the angular frequency $\omega_i$.

The foregoing and other objects, features and advantages of the present invention will become more readily apparent from the following detailed description of a preferred embodiment of the invention which proceeds with reference to the accompanying drawings.

BRIEF DESCRIPTION OF THE DRAWINGS

Figure 1a is a schematic view illustrating two component matching circuits of L type, according to prior art,

Figure 1b is a schematic view illustrating three component matching circuits of pi-type, according to prior art,

Figure 1c is a schematic view illustrating three component matching circuits of t-type, according to prior art,

Figure 2 illustrates a Smith chart for matching circuit including "negative load reactance" and "positive load reactance" path solutions, using a simple load + tune-type circuit, according to an example which is not part of the invention,

Figure 3 is a schematic view illustrating the matching circuit with component types for matching at two frequencies, according to an example which is not part of the invention,

Figure 4 is a schematic view illustrating the matching circuit with component types for matching at four frequencies, according to the invention,

Figure 5 is a schematic view illustrating the Smith chart for the matching circuit of figure 4,

Figures 6a, 6b and 6c : figures 6a) is a circuit diagram illustrating chamber impedance and multi-frequency matching circuit, and figure 6b) is a graph of frequency dependence of magnitude (gb) and phase (gy) of impedance as seen at reactor feedthrough, and figure 6c) as seen by source when using multi-frequency matching circuit,

Figure 7 is a schematic view illustrating two stages to improve robustness of design and to enable matching on systems with very high negative reactance,

Figure 8 is the Smith Chart showing impedance progression at two frequencies using a two-stage circuit such as in Figure 7,

Figure 9 is a schematic view illustrating a matching circuit containing a reduced number of components giving an imperfect matching, but still much better than with no matching circuit, for two frequencies, according to an example which is not part of the invention,

Figure 10 is the Smith Chart for an impedance matching circuit as in Figure 3 but using only an inductor in the Tune circuit,

Figure 11 is the Smith Chart for an impedance matching circuit as in Figure 3 but using only a capacitor in the Load circuit, and

Figure 12 is a schematic view illustrating a matching circuit containing adjustable capacitors for correcting matching in case of varying or unknown chamber impedance, according to an example which is not part of the invention.

DETAILED DESCRIPTION

Reference is now made to the drawing figures, in which like numerals or terms refer to like elements throughout the several views.

The Smith chart is a nomogram showing the value of the real part and the imaginary part of impedance. The graph thus consists of a network of a circle or arc.

The Smith chart is used to assist in solving problems with transmission lines and matching circuits. It can be used to represent many parameters including impedances, admittances, reflection coefficients, scattering parameters, noise figure circles, constant gain contours and regions for unconditional stability, including mechanical vibrations analysis. The Smith chart is plotted on the complex reflection coefficient plane in two dimensions and is scaled in normalised impedance (the most common), normalised admittance or both, using different colours to distinguish between them. The most commonly used normalization impedance is 50 ohms which is arranged on the horizontal line and illustrated by a small circle on figure 2. According to the invention, the Smith chart is used to determine values of components used in the matching circuit.

Figure 2 illustrates a Smith chart showing two solutions to reach a final load impedance which is for example 50$\Omega$.

The present invention makes use of the fact that, for a given (single) frequency of operation, when choosing components for a two component match box (such as in Figure 1a), there are in fact two solutions that will both provide matching, one which follows the "negative load reactance" path, and one which follows the "positive load reactance" path. The "negative load reactance" solution is the one for which the impedance added in series to the load results in the sum of the two having a negative reactance, whereas the inverse is true for the "positive load reactance" solution. This principle is shown in Figure 2, where the clockwise arrows out of the "Initial Load Impedance" point represent the effect of adding an impedance in series, the dotted line shows the reflection through the origin (to view the impedance as an admittance), and the last arrows represent the addition of an admittance in parallel.

The present invention comprises a two port, passive electrical circuit (dubbed a multi-frequency matching box, MFMB) to adapt the electrical impedance of a capacitively coupled plasma processing system (CCP-PS) so that at multiple frequencies ($f_n$), the input

impedance is similar or equal to the output impedance of the power source, therefore maximizing electrical power transfer.

The points indicated on figure 2 as "1. Positive Load Reactance Path" and "1. Negative Load Reactance Path" are points $\pm x_{match}$ (normalised), for the ideal solution to the matching problem. These points correspond to normalized impedances ($z=r+ix$) for which the real part $g$ of the normalized admittance ($y=1/z=g+i\,b$) is equal to 1. The position of these points depend on the normalized resistance, $r$, of the circuit to be matched, and can be calculated as

$$x_{match}^{\;2} = r - r^2$$

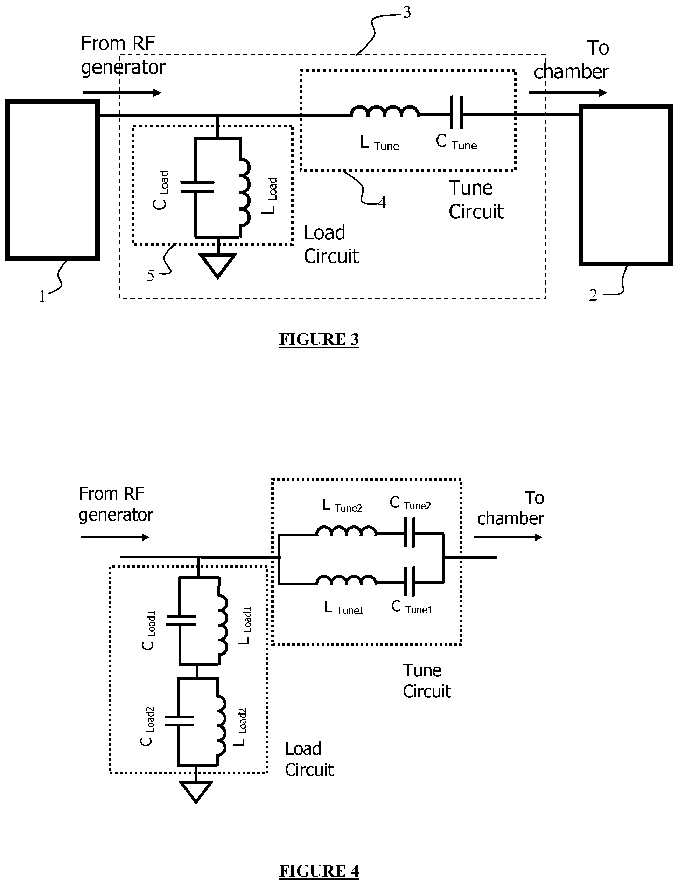

From this principle, a simple circuit can be constructed to match simultaneously a given pair of frequencies, where the "Tune Circuit" is a series connected inductor-capacitor pair, and the "Load Circuit" consists of a parallel-connected inductor-capacitor pair. Such a circuit is shown in **Figure 3,** and the component values are chosen in the following way:

- for any set of two frequencies at which the match should be made, the two sets of two components (pairs of one inductor and one capacitor) are chosen such that at the lower frequency, the circuit follows a negative load reactance path, and for the higher, it follows a positive load reactance path, and
- in the "Tune" part of the circuit, the pair of components are placed in series, and in the "Load" part of the circuit, the pair of components are placed in parallel.

It may be noted that a real solution exists only when r<1. For r>1, an analogous method may be used by first placing a "Load" circuit in parallel, and then a "Tune" circuit in series.

**Figure 3** shows a RF generator 1 as multi-frequency power source which is intended to power the CCP-PS illustrated as a chamber 2. The matching circuit 3 according to an example which is not part of the present invention, comprises a tune circuit 4 and a load circuit 5. The tune circuit 4 is connected in series to the chamber 2. The load circuit 5 is connected in parallel to the series-connected tune circuit 4 and chamber 2. Thus, the load circuit 5 has one end connected to the RF generator output and the other to signal ground.

The tune circuit 4 comprises a capacitor $C_{tune}$ and an inductor $L_{tune}$ connected in series, and therefore between the chamber 2 and the RF generator 1.

The load circuit 5 comprises a capacitor $C_{load}$ and an inductor $L_{load}$ connected in parallel, and therefore between the RF generator output and signal ground.

Additional pairs of frequencies are added in this way:

- for each additional pair of frequencies, similar circuits are added in parallel for the "Tune" part of the matching circuit, and in series for the "Load" part.
- To a first approximation, the other component pairs can be assumed to be an infinite or zero impedance for the "Tune" or "Load" parts, respectively, and can thus be neglected for the initial guess for component values. The residual, finite impedance can then be corrected through an iterative process.

In other words, components values for each pair of frequencies are first determined, then an iterative process is carried out to take into account the probably real contribution of other pairs of frequencies. Alternatively, an ideal solution may be calculated in one step using the full set of circuit equations.

An example circuit for which matching is obtained for four frequencies is shown in **Figure 4.** In the "Tune" circuit, series connected inductor-capacitor pairs are connected in parallel. As a first approximation, at frequencies far below and far above their resonant frequency ($\omega = (LC)^{1/2}$), each series-connected inductor-capacitor pair acts like an open circuit, and can be ignored when guessing the correct values for the other series-connected inductor-capacitor pair. On figure 4, the capacitor $C_{tune1}$ and the inductor $L_{tune1}$ allow the adaptation of a first pair of frequencies. The capacitor $C_{tune2}$ and the inductor $L_{tune2}$ allow the adaptation of a second pair of frequencies. capacitor $C_{load2}$ and the inductor $L_{load2}$ allow the adaptation of the second pair of frequencies.

As an example according to the present invention, it is described now a case of matching a plasma chamber modelled by a 2 $\Omega$ resistor in series with a 15nH inductor and a 700pF capacitor. When normalized to Z=50$\Omega$, these components give the following values:

$$z_{chamber}(15MHz) = 0.04 - j0.275$$

$$z_{chamber}(30MHz) = 0.04 - j0.095$$

$$z_{chamber}(60MHz) = 0.04 + j0.037$$

$$z_{chamber}(90MHz) = 0.04 + j0.119$$

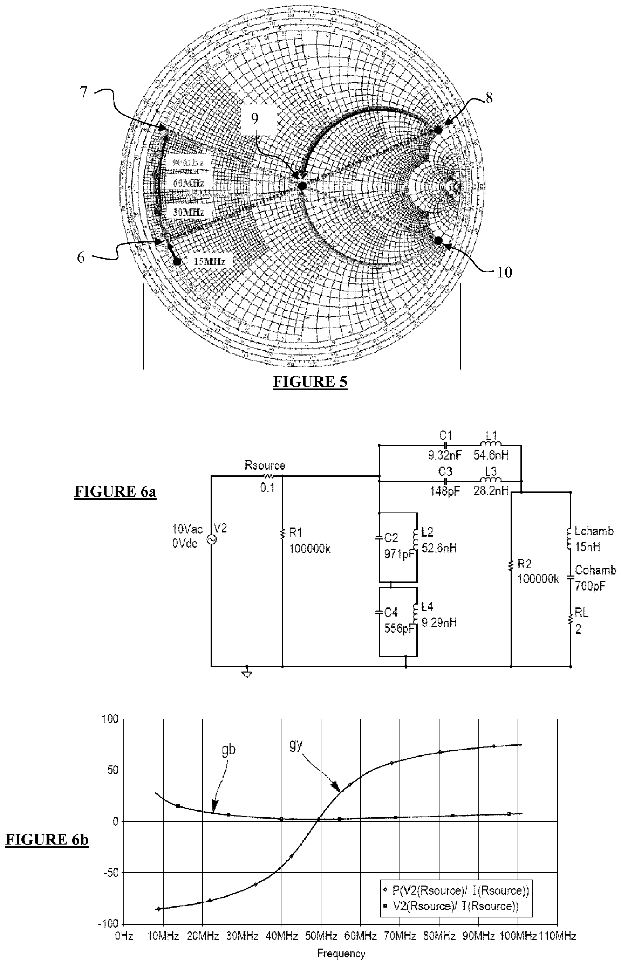

and are presented on the Smith Chart in figure 5. This combination models for example a realistic small area laboratory reactor. For this example, it is desired that the RF generator see a real 50 ohms load at 15, 30, 60 and 90MHz, simultaneously. The desired path for these four frequencies can be seen in Figure 5. The two dotted lines concern the paths of the two solutions that will both provide matching. Among the pair of frequencies 15MHz and 30MHz, the negative load reactance path is followed by the 15MHz frequency. The positive load reactance path is followed by the 30MHz frequency. For the pair of frequencies 60MHz and 90MHz, the negative load reactance path is followed by the 60MHz frequency. The positive load reactance path is followed by the 90MHz frequency.

As can be seen from Figure 5, the two pairs of components that are chosen for the Tune circuit should give normalized impedance values of z = +/-0.196 ($x_{match}$ =(r-r²)^{1/2} with r=0.04) at each corresponding pair of frequencies. Therefore, the normalized impedance of the Tune circuit should be equal to:

$$x_{Tune}(15MHz) = j0.085$$

$$x_{Tune}(30MHz) = j0.285$$

$$x_{Tune}(60MHz) = -j0.227$$

$$x_{Tune}(90MHz) = j0.071$$

For example, for the pair of frequencies 15 and 30 MHz, the values of capacitor $C_{tune1}$ and the inductor $L_{tune1}$ are determined to reach simultaneously and respectively the first "negative" point 6 and the first "positive" point 7 as depicted on figure 5. Then, the inductor $L_{load1}$ and capacitor $C_{load1}$ are used to simultaneously reach the resistance 9 from the second "negative" point 8 for 15MHz, and to reach the resistance 9 from the second "positive" point 10 for the frequency 30 MHz.

Initially, values are chosen assuming that the contribution of the circuit in parallel is negligible. Through an iterative process to take into account the contribution at frequencies 15 and 30 MHz of the residual impedance of the components chosen for the frequencies at 60 and 90 MHz (and vice-versa), the final chosen values are:

$$C_{Tune1} = 9.32 \text{ nF}$$

$$L_{Tune1} = 54.6 \text{ nH}$$

$$C_{Tune2} = 148.0 \text{ pF}$$

$$L_{Tune2} = 28.2 \text{ nH}$$

A similar process is performed for the Load circuit, and the following final component values are chosen:

$$C_{Load1} = 971 \text{ pF}$$

$$L_{Load1} = 52.6 \text{ nH}$$

$$C_{Load2} = 556 \text{ pF}$$

$$L_{Load2} = 9.29 \text{ nH}$$

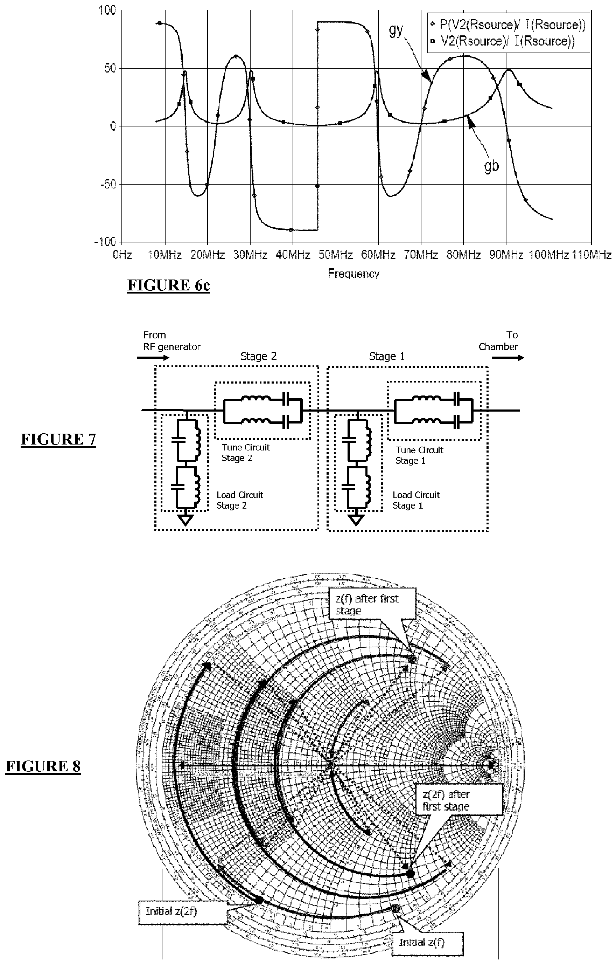

A computer simulation of this circuit (shown in Figure 6a) shows that indeed, within the approximations made in the original reading of the Smith chart, the circuit designed transforms the impedance of the load (Figure 6b) such that the source sees a load impedance of 50+j0 at the four frequencies chosen (Figure 6c). Figure 6b shows the magnitude of the load impedance seen at the chamber feedthrough. It comprises a concave curve gb varying between a value of 25ohms at 10MHz to a value of around 10 ohms at 100MHz. A minimum of around zero ohm is obtained at 50 MHz. The curve denoted "gy" indicates the phase of the impedance seen at the chamber feedthrough, which has the form of an "S" shape between -90 degrees at 9MHz to 75 degrees at 100MHz; the inflection point being for zero ohm at 50MHz.

On figure 6c, it can be seen that for each of the frequencies 15, 30, 60 and 90 MHz, the magnitude of the impedance (curve gb) is 50 ohms, and the phase (gy) is 0 degrees.

For some reactor designs, particularly those with a very large negative reactance, it may be difficult to perform the above matching technique, as for any Tune circuit (i.e. any series-connected component pair) the impedance at the lower frequency is always more negative than the one at the higher frequency. The threshold design situation exists when with no $C_{tune1}$ is present, and a certain value of $L_{tune1}$ displaces the two impedances exactly to $\pm x_{match}$. To describe this as a threshold condition, one chooses a value of $L_{tune1}$ which displaces the two impedances so that they are complex conjugates ($z=r \pm x_{test}$). Removing the normalization ($Z=(r+ix)Z_0=R+iX$), this gives:

$$X(\omega_1) + \omega_1 L = -X(\omega_2) - \omega_2 L$$

$$L = -\frac{X(\omega_2) + X(\omega_1)}{\omega_2 + \omega_1}$$

The resulting reactances after adding the inductance ($X(\omega_1)+\omega_1 L$ and $X(\omega_2)+\omega_2 L$) must be a pair of points which fall between the points $\pm X_{match}$, as the subsequent addition of a capacitor can only make the separation between these points larger. Selecting the value of inductance above, this condition can be expressed as:

$$X(\omega_2) - \frac{\omega_2}{\omega_2 + \omega_1}\big(X(\omega_2) + X(\omega_1)\big) \leq X_{match}$$

$\omega_i$ being the i-th angular frequency, and $X(\omega_i)$ being the reactance of the load at angular frequency $\omega_i$.

If this equation is not satisfied, then no values can be chosen for $C_{tune1}$ and $L_{tune1}$ to obtain a perfect match in a single stage. To address such design situations in the requirement of a perfect match, Figure 7 shows the use of a multistage, multi-frequency match box. In this design, multiple stages are connected in series, each with an internal design similar to that of Figure 4. Each stage contains a "Load" and "Tune" set of components. It should be noted that some components in a stage may in fact be set to a null value (or removed) for simplicity's sake. In the simplest case, this may consist of adding a single component in series or in parallel at the RF input of the chamber, i.e. setting most components to null values in stage 1.

The impedance progression that results from the use of a multistage circuit (as in Figure 7) is shown in the Smith chart of Figure 8. The impedances seen at the input to stage 1 (rather than 50 Ω) for *f* and *2f* contain slightly larger real parts compared to their initial value, but oppositely signed reactive parts. On the Smith chart of figure 8, the dotted lines represent the transformation of the impedance to an admittance (to add a parallel admittance circuit). The initial point z(f) follows the negative load reactance path to reach an intermediate impedance. This negative load reactance path comprises a first rotation, a first impedance-to-admittance transformation, a second rotation and a second impedance-to-admittance transformation. Similarly, the initial point z(2f) follows the positive load reactance path to reach an intermediate impedance. This positive load reactance path comprises a first rotation, a first impedance-to-admittance transformation, a second rotation and a second impedance-to-admittance transformation.

The selection of the components for stage 2 can now be made, with the existence of a solution for the circuit components now guaranteed.

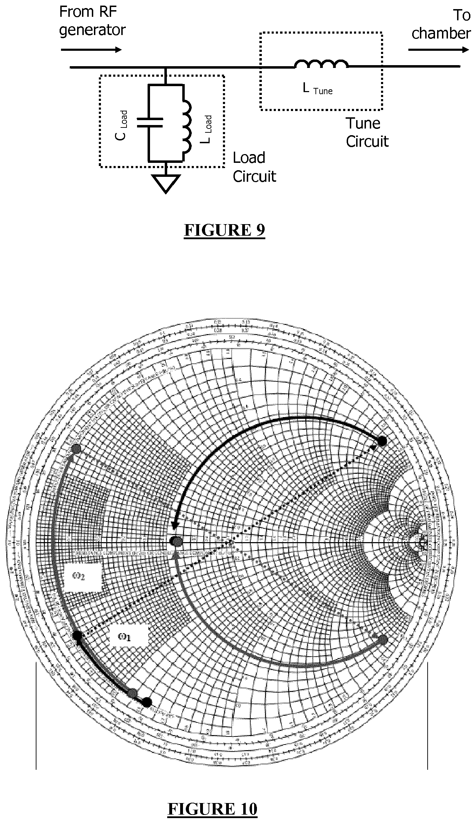

Another strategy that can be used when a perfect solution does not exist- or in the case where a less ideal match can be accepted for the sake of using fewer components - is to attempt to obtain the best possible match using fewer components. An example of such a circuit is shown in Figure 9, where the component $C_{tune1}$ has been eliminated. With respect to figure 3, only the inductor $L_{tune}$ is present in the tune circuit in series to the chamber.

To obtain the best possible match with this circuit for the two frequencies desired, one would select the value of $L_{tune}$ to displace the chamber impedances at $\omega_1$ and $\omega_2$ to be complex conjugates $\pm X_{conj}$, as already described above:

$$X(\omega_1) + \omega_1 L = -X(\omega_2) - \omega_2 L = \pm X_{conj}$$

$$L = -\frac{X(\omega_2) + X(\omega_1)}{\omega_2 + \omega_1}$$

L being an inductance, $\omega_i$ being the i-th angular frequency, and $X(\omega_i)$ being the reactance of the load at an angular frequency $\omega_i$.

When this value is chosen for $L_{Tune}$, the two values $C_{Load}$ and $L_{Load}$ can be chosen to give the best possible match (in which case, the impedance seen by the source will be completely real). This design strategy is well-visualized using the Smith chart, and is shown in Figure 10. $\omega_1$ and $\omega_2$ respectively follow the negative load reactance path and the positive load reactance paths to reach the two solutions that provide the best possible match in the Smith chart.

In this case, additionally, one may consider the example of a test point of impedance $r+x_{test}$, where r is the impedance of the load and $x_{test}$ is the normalized impedance after the Tune circuit when choosing the inductor L as described above. The power matching can immediately be known from the equivalent admittance y at this test point as given by:

$$y = g + ib_{test} = \frac{1}{r + x_{test}}$$

$$r_{match} = \frac{1}{g}$$

where g and $b_{test}$ are the normalized conductance and susceptance after the Tune circuit. $r_{match}$ is then the normalized resistance obtained when the normalized susceptance $b_{test}$ is eliminated using a load circuit.

Using this value, one can calculate the minimum possible power reflection coefficient Γ when removing this one component by:

$$\Gamma = \left|\frac{1 - r_{match}}{1 + r_{match}}\right|$$

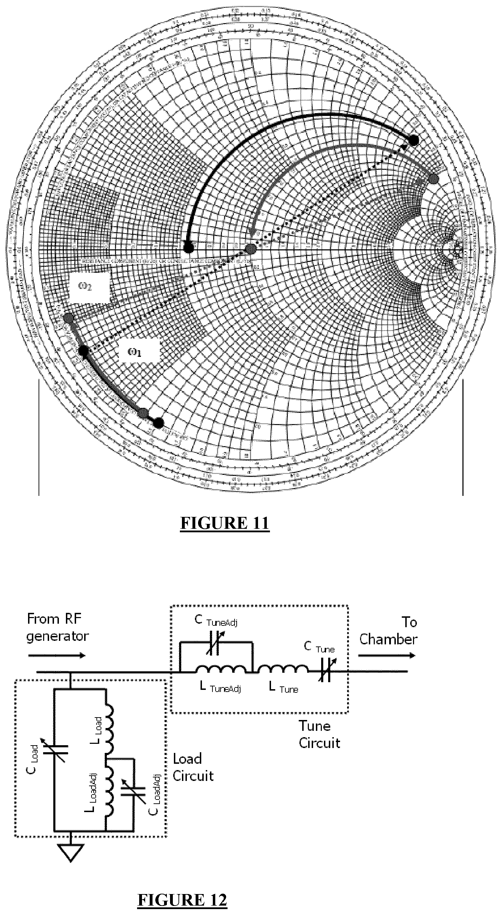

Analogously to removing a capacitor from the Tune circuit, an imperfect match can be obtained using one less component by removing $L_{Load}$ from the circuit of Figure 3. However, a clear design strategy is less clear in this case, as can be seen from the Smith chart representing this circuit in Figure 11. The relationship between the admittances of the Load circuit (namely, that the admittance will become more positive with frequency) means that this configuration can only be useful for a very specific pair of impedances as seen after the Tune circuit. Additionally, the real part of the admittances seen at the two frequencies after the Tune circuit will not have the same magnitude, and so the reflection coefficient will not be the same, and will be difficult to predict in advance.

Finally, in practice, the impedance of the chamber and plasma at the frequencies for which matching is required will not be perfectly known, and/or may be subject to drift. For this reason, all the Load and Tune capacitors in the circuits should be adjustable. Although the use of adjustable inductors would allow for a perfect match (or at least the best possible), these are not standard components. Alternatively, one may split the inductor into two inductors connected in series (for example, into $L_{Tune}$ and $L_{TuneAdj}$) with a total value equal to the calculated, ideal inductance, and then place an adjustable capacitor ($C_{TuneAdj}$) in parallel to one of them ($L_{TuneAdj}$). This may be equivalently done for the Load circuit (placing $C_{LoadAdj}$ in parallel with $L_{LoadAdj}$), and these together with $C_{Tune}$ and $C_{Load}$ giving the small degree of adjustment necessary to correct these inductive components and to give better matching at all the desired frequencies. $C_{TuneAdj}$ and $C_{LoadAdj}$ should be appropriately small so that they have a large impedance value relative to the inductors at the frequencies of interest. Figure 12 is based on figure 3 where the standard capacitors $C_{tune}$ and $C_{load}$ are replaced by adjustable capacitors, in addition to the adjustable capacitors added to emulate variable inductors. As it is easier in practice to obtain an adjustable capacitor than an adjustable inductor, each inductor is associated to an adjustable capacitor. The tune inductor is associated with an adjustable capacitor $C_{tuneadj}$ (partially in parallel). The load inductor is associated with an adjustable capacitor $C_{loadadj}$ (partially in parallel).

Numerous variations and modifications will become apparent to those skilled in the art once the above disclosure is fully appreciated. It is intended that the following claims be interpreted to embrace all such variations and modifications.

**Claims**

1.    A matching circuit (3) suitable for adapting electrical impedance simultaneously for at least two pairs of frequencies, between a capacitively coupled plasma reactor (2) as load and a RF generator (1) as source, the first pair of a higher and a lower frequency being a fundamental frequency with one of its harmonics, said matching circuit comprises at least a load and tune L-type stage (3), the L-type stage comprising:

> - a first tune circuit (4) connected in series between the source (1) and the load (2) and comprising at least both an inductor ($L_{Tune1}$) and a capacitor ($C_{Tune1}$) in series,
> - a first load circuit (5) connected, at a first end between the source (1) and said first tune circuit (4) and at a second end to a signal ground, said first load circuit comprising at least both an inductor ($L_{Load1}$) and a capacitor ($C_{Load1}$) in parallel,

wherein the component values of the tune and load circuits are chosen such that, for the lower frequency, the matching circuit follows a negative load reactance path in a Smith chart, and for the higher frequency, the matching circuit follows a positive load reactance path in the Smith chart, the negative load reactance path being the one for which the impedance of the part of the matching circuit added in series to the load results in the sum of the two having a negative reactance, whereas the sum of the two has a positive reactance for the positive load reactance path,

wherein for the second and each additional pair of frequencies, the L-type stage further comprises :

> - an additional tune circuit comprising at least both an inductor ($L_{Tune2}$) and a capacitor ($C_{Tune2}$) in series, said additional tune circuit being in parallel to the first tune circuit ($L_{tune1}$, $C_{tune1}$) and
> - an additional load circuit comprising at least both an inductor ($L_{Load2}$) and a capacitor ($C_{Load2}$) in parallel, said additional load circuit being in series with the first load circuit ($L_{Load1}$, $C_{Load1}$)

the component values of the additional tune and load circuits are chosen such that for the lower frequency of the second and each additional pair of frequencies, the matching circuit follows a negative load reactance path in a Smith chart, and for the higher frequency of the second and each additional pair of frequencies, the matching circuit follows a positive load reactance path in the Smith chart, respectively.

2.    Matching circuit according to claim 1, **characterized in that** it comprises multiple "load and tune" L-type stages (stage1, stage 2) connected in series.

3.    Matching circuit according to claim 2, **characterized in that** at least one of the stages (stage1, stage 2) comprises an adjustable capacitor.

4.    A method for designing a matching circuit (3) suitable for adapting electrical impedance simultaneously for at least two pairs of frequencies, between a capacitively coupled plasma reactor (2) as load and a RF generator (1) as source, the first pair of a higher and a lower frequency being a fundamental frequency with one of its harmonics , said matching circuit (3) comprises at least a load and tune L-type stage (3), the L-type stage comprising:

- a first tune circuit (4) connected in series between the source (1) and the load (2) and comprising at least both an inductor ($L_{Tune1}$) and a capacitor ($C_{Tune1}$) in series,
- a first load circuit (5) connected, at a first end between the source (1) and said first tune circuit (4) and at a second end to a signal ground, said first load circuit comprising at least both an inductor ($L_{Load1}$) and a capacitor ($C_{Load1}$) in parallel,

wherein the method comprises the step of using a Smith chart to determine the components values of the tune and load circuits by following a negative load reactance path in said Smith chart for the lower frequency, and by following a positive load reactance path in said Smith chart for the higher frequency, the negative load reactance path being the one for which the impedance of the part of the matching circuit added in series to the load results in the sum of the two having a negative reactance, whereas the sum of the two has a positive reactance for the positive load reactance path,

wherein for the second and each additional pair of frequencies, the L-type stage further comprises:

- an additional tune circuit comprising at least both an inductor ($L_{Tune2}$) and a capacitor ($C_{Tune2}$) in series which is added in parallel to the first tune circuit ($L_{Tune1}$, $C_{Tune1}$) and
- an additional load circuit comprising at least both an inductor ($L_{Load2}$) and a capacitor ($C_{Load2}$) in parallel which is added in series to the first load circuit ($L_{Load1}$, $C_{Load1}$) and

wherein the method comprises the step of using a Smith chart to determine the component values of the additional tune and load circuits by following a negative load reactance path in said Smith chart for the lower frequency of the second and each additional pair of frequencies, and by following a positive load reactance path in said Smith chart for the higher frequency of the second and each additional pair of frequencies, respectively.

5. Method according to claim 4, **characterized in that** the component values of the additional components are calculated by first assuming that the values for the first tune circuit or the first load circuit are infinite or zero impedance respectively, then an iterative process is carried out to correct the additional components' values.

6. Method according to claim 4 or 5, **characterized in that** a perfect match is obtainable in a single stage when :

$$X(\omega_2) - \frac{\omega_2}{\omega_2 + \omega_1}\left(X(\omega_2) + X(\omega_1)\right) \leq X_{match}$$

$\pm X_{match}$ being the two solutions that provide matching in said Smith chart, one following the negative load reactance path and one following the positive load reactance path; $\omega_i$ being the i-th angular frequency, and $X(\omega_i)$ being the reactance of the load at the angular frequency $\omega_i$.

**Patentansprüche**

1. Anpassungsschaltung (3), die zum Adaptieren der elektrischen Impedanz gleichzeitig für mindestens zwei Frequenzpaare zwischen einem kapazitiv gekoppelten Plasmareaktor (2) als Last und einem HF-Generator (1) als Quelle geeignet ist, wobei das erste Paar einer höheren und einer niedrigeren Frequenz eine Grundfrequenz mit einer ihrer Oberschwingungen ist, wobei die Anpassungsschaltung mindestens eine Last- und Abstimmungs-L-Stufe (3) umfasst, wobei die L-Stufe umfasst:

- eine erste Abstimmungsschaltung (4), die zwischen der Quelle (1) und der Last (2) in Reihe geschaltet ist und mindestens beide, einen Induktor ($L_{Tune1}$) und einen Kondensator ($C_{Tune1}$) in Reihe umfasst,
- eine erste Lastschaltung (5), die an einem ersten Ende zwischen der Quelle (1) und der ersten Abstimmungsschaltung (4) und an einem zweiten Ende mit einer Signalmasse geschaltet ist, wobei die erste Lastschaltung mindestens beides, einen Induktor ($L_{Load1}$) und einen Kondensator ($C_{Load1}$) parallel umfasst,

wobei die Komponentenwerte der Abstimmungs- und Lastschaltungen so gewählt sind, dass für die niedrigere Frequenz die Anpassungsschaltung einem negativen Lastreaktanzpfad in einem Smith-Diagramm folgt, und für die höhere Frequenz die Anpassungsschaltung einem positiven Lastreaktanzpfad in dem Smith-Diagramm folgt, wobei der negative Lastreaktanzpfad der eine ist, für den die Impedanz des Teils der Anpassungsschaltung, die in Reihe zu der Last hinzugefügt wird, dazu führt, dass die Summe der beiden eine negative Reaktanz aufweist, während die Summe der beiden eine positive Reaktanz für den positiven Lastreaktanzpfad aufweist, wobei für das zweite und jedes zusätzliche Paar von Frequenzen die L-Stufe weiter umfasst:

- eine zusätzliche Abstimmungsschaltung, die mindestens beide, einen Induktor ($L_{Tune2}$) und einen Kondensator ($C_{Tune2}$) in Reihe umfasst, wobei die zusätzliche Abstimmungsschaltung parallel zu der ersten Abstimmungsschaltung ($L_{Tune1}$, $C_{Tune1}$) steht, und

- eine zusätzliche Lastschaltung, die mindestens beide, einen Induktor ($L_{Load2}$) und einen Kondensator ($C_{Load2}$) parallel umfasst, wobei die zusätzliche Lastschaltung in Reihe mit der ersten Lastschaltung ($L_{Load1}$, $C_{Load1}$) steht

die Komponentenwerte der zusätzlichen Abstimmungs- und Lastschaltungen so gewählt werden, dass für die niedrigere Frequenz des zweiten und jedes zusätzlichen Paares von Frequenzen die Anpassungsschaltung einem negativen Lastreaktanzpfad in einem Smith-Diagramm folgt, und für die höhere Frequenz der zweiten und jedes zusätzlichen Paares von Frequenzen die Anpassungsschaltung jeweils einem positiven Lastreaktanzpfad in dem Smith-Diagramm folgt.

2. Anpassungsschaltung nach Anspruch 1, **dadurch gekennzeichnet, dass** sie mehrere in Reihe geschaltete "Last- und Abstimmungs" L-Stufen (stage 1, stage 2) umfasst.

3. Anpassungsschaltung nach Anspruch 2, **dadurch gekennzeichnet, dass** mindestens eine der Stufen (stage 1, stage 2) einen einstellbaren Kondensator umfasst.

4. Verfahren zur Auslegung einer Anpassungsschaltung (3), zum Adaptieren der elektrischen Impedanz gleichzeitig für mindestens zwei Frequenzpaare zwischen einem kapazitiv gekoppelten Plasmareaktor (2) als Last und einem HF-Generator (1) als Quelle geeignet ist, wobei das erste Paar einer höheren und einer niedrigeren Frequenz eine Grundfrequenz mit einer ihrer Oberschwingungen ist, wobei die Anpassungsschaltung (3) mindestens eine Last- und Abstimmungs-L-Stufe (3) umfasst, wobei die L-Stufe umfasst:

- eine erste Abstimmungsschaltung (4), die zwischen der Quelle (1) und der Last (2) in Reihe geschaltet ist und mindestens beide, einen Induktor ($L_{Tune1}$) und einen Kondensator ($C_{Tune1}$) in Reihe umfasst,
- eine erste Lastschaltung (5), die an einem ersten Ende zwischen der Quelle (1) und der ersten Abstimmungsschaltung (4) und an einem zweiten Ende mit einer Signalmasse geschaltet ist, wobei die erste Lastschaltung mindestens beide, einen Induktor ($L_{Load1}$) und einen Kondensator ($C_{Load1}$) parallel umfasst,

wobei das Verfahren den Schritt des Verwendens eines Smith-Diagramms zum Bestimmen der Komponentenwerte der Abstimmungs- und Lastschaltungen durch Folgen eines negativen Lastreaktanzpfades in dem Smith-Diagramm für die niedrigere Frequenz und durch Folgen eines positiven Lastreaktanzpfades in dem Smith-Diagramm für die höhere Frequenz umfasst, der negative Lastreaktanzpfad, der eine ist, für den die Impedanz des Teils der Anpassungsschaltung, der in Reihe zu der Last hinzugefügt wird, dazu führt, dass die Summe der beiden eine negative Reaktanz aufweist, während die Summe der beiden eine positive Reaktanz für den positiven Lastreaktanzpfad aufweist, wobei für das zweite und jedes zusätzliche Paar von Frequenzen die L-Stufe weiter umfasst:

- eine zusätzliche Abstimmungsschaltung, die mindestens beide, einen Induktor ($L_{Tune2}$) und einen Kondensator ($C_{Tune2}$) in Reihe umfasst, der parallel zu der ersten Abstimmungsschaltung ($L_{Tune1}$, $C_{Tune1}$) hinzugefügt wird und
- eine zusätzliche Lastschaltung, die mindestens beide, einen Induktor ($L_{Load2}$) und einen Kondensator ($C_{Load2}$) parallel umfasst, der in Reihe zu der ersten Lastschaltung ($L_{Load1}$, $C_{Load1}$) hinzugefügt wird und

wobei das Verfahren den Schritt des Verwendens eines Smith-Diagramms zum Bestimmen der Komponentenwerte der zusätzlichen Abstimmungs- und Lastschaltungen durch Folgen eines negativen Lastreaktanzpfades in dem Smith-Diagramm für die niedrigere Frequenz des zweiten und jedes zusätzlichen Paares von Frequenzen und durch Folgen eines positiven Lastreaktanzpfades in dem Smith-Diagramm für die höhere Frequenz der zweiten bzw. jedes zusätzlichen Paares von Frequenzen umfasst.

5. Verfahren nach Anspruch 4, **dadurch gekennzeichnet, dass** die Komponentenwerte der zusätzlichen Komponenten berechnet werden, indem zunächst davon ausgegangen wird, dass die Werte für die erste Abstimmungsschaltung oder die erste Lastschaltung jeweils unendliche oder null Impedanz sind, dann ein iterativer Prozess durchgeführt wird, um die Werte der zusätzlichen Komponenten zu korrigieren.

6. Verfahren nach Anspruch 4 oder 5, **dadurch gekennzeichnet, dass** eine perfekte Anpassung in einer einzigen Stufe erhältlich ist, wenn:

$$X(\omega_2) - \frac{\omega_2}{\omega_2 + \omega_1}\left(X(\omega_2) + X(\omega_1)\right) \le X_{match}$$

wobei $\pm X_{Anpassung}$ die beiden Lösungen sind, die eine Anpassung in dem Smith-Diagramm bereitstellen, wobei eine dem negativen Lastreaktanzpfad folgt und eine dem positiven Lastreaktanzpfad folgt;

$\omega_i$ die i-te Winkelfrequenz ist, und $X(\omega_i)$ die Reaktanz der Last bei der Winkelfrequenz $\omega_i$ ist.

## Revendications

1. Circuit d'adaptation (3) approprié pour adapter une impédance électrique simultanément pour au moins deux couples de fréquences, entre un réacteur à plasma couplé de manière capacitive (2) en tant que charge et un générateur RF (1) en tant que source, le premier couple d'une fréquence supérieure et d'une fréquence inférieure étant une fréquence fondamentale avec une seule de ses harmoniques, ledit circuit d'adaptation comprend au moins un étage de type L charge et accord (3), l'étage de type L comprenant :

   - un premier circuit d'accord (4) relié en série entre la source (1) et la charge (2) et comprenant au moins tant une bobine d'inductance ($L_{Tune1}$) qu'un condensateur ($C_{Tune1}$) en série,
   - un premier circuit de charge (5) relié, au niveau d'une première extrémité entre la source (1) et ledit premier circuit d'accord (4) et au niveau d'une seconde extrémité à une masse de signal, ledit premier circuit de charge comprenant au moins tant une bobine d'inductance ($L_{Load1}$) qu'un condensateur ($C_{Load1}$) en parallèle,

   dans lequel les valeurs de composants des circuits de charge et d'accord sont choisies de sorte que, pour la fréquence inférieure, le circuit d'adaptation suit un chemin de réactance de charge négative dans un abaque de Smith, et pour la fréquence supérieure, le circuit d'adaptation suit un chemin de réactance de charge positive dans l'abaque de Smith, le chemin de réactance de charge négative étant celui pour lequel l'impédance de la partie du circuit d'adaptation ajoutée en série à la charge aboutit à la somme des deux présentant une réactance négative, tandis que la somme des deux présente une réactance positive pour le chemin de réactance de charge positive,
   dans lequel pour le deuxième et chaque couple supplémentaire de fréquences, l'étage de type L comprend en outre :

   - un circuit d'accord supplémentaire comprenant au moins tant une bobine d'inductance ($L_{Tune2}$) qu'un condensateur ($C_{Tune2}$) en série, ledit circuit d'accord supplémentaire étant en parallèle avec le premier circuit d'accord ($L_{tune1}$, $C_{tune1}$), et
   - un circuit de charge supplémentaire comprenant au moins tant une bobine d'inductance ($L_{Load2}$) qu'un condensateur ($C_{Load2}$) en parallèle, ledit circuit de charge supplémentaire étant en série avec le premier circuit de charge ($L_{Load1}$, $C_{Load1}$)

   les valeurs de composants des circuits de charge et d'accord supplémentaires sont choisies de sorte que pour la fréquence inférieure du deuxième et de chaque couple supplémentaire de fréquences, le circuit d'adaptation suit un chemin de réactance de charge négative dans un abaque de Smith, et pour la fréquence supérieure du deuxième et de chaque couple supplémentaire de fréquences, le circuit d'adaptation suit un chemin de réactance de charge positive dans l'abaque de Smith, respectivement.

2. Circuit d'adaptation selon la revendication 1, **caractérisé en ce qu'**il comprend de multiples étages de type L «charge et accord» (stage 1, stage 2) reliés en série.

3. Circuit d'adaptation selon la revendication 2, **caractérisé en ce qu'**au moins un des étages (stage 1, stage 2) comprend un condensateur réglable.

4. Procédé pour concevoir un circuit d'adaptation (3) approprié pour adapter une impédance électrique simultanément pour au moins deux couples de fréquences, entre un réacteur à plasma couplé de manière capacitive (2) en tant que charge et un générateur RF (1) en tant que source, le premier couple d'une fréquence supérieure et d'une fréquence inférieure étant une fréquence fondamentale avec une seule de ses harmoniques, ledit circuit d'adaptation (3) comprend au moins un étage de type L charge et accord (3), l'étage de type L comprenant :

   - un premier circuit d'accord (4) relié en série entre la source (1) et la charge (2) et comprenant au moins tant une bobine d'inductance ($L_{Tune1}$) qu'un condensateur ($C_{Tune1}$) en série,
   - un premier circuit de charge (5) relié, au niveau d'une première extrémité entre la source (1) et ledit premier circuit d'accord (4) et au niveau d'une seconde extrémité à une masse de signal, ledit premier circuit de charge comprenant au moins tant une bobine d'inductance ($L_{Load1}$) qu'un condensateur ($C_{Load1}$) en parallèle,

   dans lequel le procédé comprend l'étape consistant à utiliser un abaque de Smith pour déterminer les valeurs de composants des circuits de charge et d'accord en suivant un chemin de réactance de charge négative dans ledit abaque de Smith pour la fréquence inférieure, et en suivant un chemin de réactance de charge positive dans ledit abaque de Smith pour la fréquence supérieure, le chemin de réactance de charge négative étant celui pour lequel l'impédance de la partie du circuit d'adaptation supplémentaire en série avec la charge aboutit à la somme des deux présentant une réactance négative, tandis que la somme des deux présente une réactance positive pour le chemin de réactance de charge positive,

dans lequel pour le deuxième et chaque couple supplémentaire de fréquences, l'étage de type L comprend en outre :

- un circuit d'accord supplémentaire comprenant au moins tant une bobine d'inductance ($L_{Tune2}$) qu'un condensateur ($C_{Tune2}$) en série qui est ajouté en parallèle au premier circuit d'accord ($L_{Tune1}$, $C_{Tune1}$) et
- un circuit de charge supplémentaire comprenant au moins tant une bobine d'inductance ($L_{Load2}$) qu'un condensateur ($C_{Load2}$) en parallèle qui est ajouté en série au premier circuit de charge ($L_{Load1}$, $C_{Load1}$) et

dans lequel le procédé comprend l'étape consistant à utiliser un abaque de Smith pour déterminer les valeurs de composants des circuits de charge et d'accord supplémentaires en suivant un chemin de réactance de charge négative dans ledit abaque de Smith pour la fréquence inférieure du deuxième et de chaque couple supplémentaire de fréquences, et en suivant un chemin de réactance de charge positive dans ledit abaque de Smith pour la fréquence supérieure du deuxième et de chaque couple supplémentaire de fréquences, respectivement.

5. Procédé selon la revendication 4, **caractérisé en ce que** les valeurs de composants des composants supplémentaires sont calculées en supposant d'abord que les valeurs pour le premier circuit d'accord ou le premier circuit de charge sont respectivement infinies ou d'impédance nulle, ensuite un processus itératif est effectué pour corriger les valeurs des composants supplémentaires.

6. Procédé selon la revendication 4 ou 5, **caractérisé en ce qu'**une adéquation parfaite peut être obtenue dans un étage unique lorsque :

$$X(\omega_2) - \frac{\omega_2}{\omega_2 + \omega_1}\left(X(\omega_2) + X(\omega_1)\right) \le X_{match}$$

$\pm X_{match}$ étant les deux solutions qui fournissent une adaptation dans ledit abaque de Smith, une suivant le chemin de réactance de charge négative et une suivant le chemin de réactance de charge positive ; $\omega_i$ étant la fréquence angulaire de rang i et $X(\omega_i)$ étant la réactance de la charge à la fréquence angulaire $\omega_i$.

**FIGURE 1 PRIOR ART**

**FIGURE 2**

From RF
generator

To
chamber

L Tune    C Tune

Tune
Circuit

C Load    L Load

Load
Circuit

**FIGURE 3**

From RF
generator

To
chamber

L Tune2    C Tune2

L Tune1    C Tune1

Tune
Circuit

C Load1    L Load1

C Load2    L Load2

Load
Circuit

**FIGURE 4**

**FIGURE 5**

**FIGURE 6a**

**FIGURE 6b**

**FIGURE 6c**

**FIGURE 7**

**FIGURE 8**

From RF
generator

To
chamber

$L_{Tune}$

$C_{Load}$    $L_{Load}$

Tune
Circuit

Load
Circuit

**FIGURE 9**

$\omega_2$

$\omega_1$

**FIGURE 10**

**FIGURE 11**

**FIGURE 12**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6331815 B1
- US 2006170492 A
- US 2007194628 A
- US 2007118067 A

**Non-patent literature cited in the description**

- The Electrical Aysmmetry Effect - A novel and simple method for separate control of ion energy and flux in capacitively coupled RF discharges. *Journal of Physics,* April 2009, vol. 162 (1), 12010